# EUROPEAN PATENT SPECIFICATION

(11) **EP 4 652 825 B1**
(45) Date of publication and mention of the grant of the patent: **02.12.2026**
(21) Application number: 24701507.6
(22) Date of filing: 16.01.2024
(51) Int. Cl.: H10N 50/10, H10N 50/80

(54) **SPIN CURRENT MAGNETIZATION ROTATING ELEMENT, MAGNETORESISTIVE EFFECT ELEMENT, AND MAGNETIC MEMORY**
SPINSTROMMAGNETISIERUNGSDREHELEMENT, ELEMENT MIT MAGNETORESISTIVEM EFFEKT UND MAGNETISCHER SPEICHER
ÉLÉMENT ROTATIF DE MAGNÉTISATION PAR COURANT DE SPIN, ÉLÉMENT À EFFET MAGNÉTORÉSISTIF ET MÉMOIRE MAGNÉTIQUE

(30) Priority: 17.01.2023 US 202363439447 P
(43) Date of publication of application: 26.11.2025
(73) Proprietor: The University of Tokyo, Bunkyo-ku, Tokyo 113-8654 (JP); JSR Corporation, Tokyo 105-8640 (JP)
(72) Inventor: ISHIKAWA, Takahiro, Tokyo 113-8654 (JP); AKASHI, Ryosuke, Tokyo 113-8654 (JP); KUBO, Koutarou, Tokyo 105-8640 (JP); TOGA, Yuuta, Minato-ku (JP); INUKAI, Kouji, Tokyo 105-8640 (JP); RITTAPORN, Itti, Tokyo 105-8640 (JP); HAYASHI, Masamitsu, Tokyo 113-8654 (JP); TSUNEYUKI, Shinji, Tokyo 113-8654 (JP)
(74) Representative: Becker, Eberhard
(86) International application number: PCT/IB2024/050407
(87) International publication number: WO 2024/154050

(56) References cited:
- US-A1- 2019 006 581
- US-A1- 2022 149 269
- BUHOT J ET AL: "Experimental evidence for orthorhombic Fddd crystal structure in elemental yttrium above 100 GPa", ARXIV.ORG, CORNELL UNIVERSITY LIBRARY, 201 OLIN LIBRARY CORNELL UNIVERSITY ITHACA, NY 14853, 11 August 2020 (2020-08-11), XP081737894
- HE Y ET AL: "Spin Hall conductivity in Pt films under tetragonal and orthorhombic distortions", PHYSICA B: CONDENSED MATTER, ELSEVIER, AMSTERDAM, NL, vol. 605, 6 January 2021 (2021-01-06), XP086486496, ISSN: 0921-4526, [retrieved on 20210106], DOI: 10.1016/J.PHYSB.2020.412654
- PAI C ET AL: "Spin transfer torque devices utilizing the giant spin Hall effect of tungsten", APPLIED PHYSICS LETTERS, AMERICAN INSTITUTE OF PHYSICS, 2 HUNTINGTON QUADRANGLE, MELVILLE, NY 11747, vol. 101, no. 12, 17 September 2012 (2012-09-17), XP012164618, ISSN: 0003-6951, [retrieved on 20120918], DOI: 10.1063/1.4753947
- ISHIKAWA T ET AL: "Large intrinsic spin Hall conductivity in orthorhombic tungsten", PHYSICAL REVIEW MATERIALS, vol. 7, no. 2, 15 February 2023 (2023-02-15), XP093148502, ISSN: 2475-9953, Retrieved from the Internet <URL:https://journals.aps.org/prmaterials/pdf/10.1103/PhysRevMaterials.7.026202> DOI: 10.1103/PhysRevMaterials.7.026202

## Description

### TECHNICAL FIELD

The present disclosure relates to a spin current magnetization rotating element, a magnetoresistive effect element, and a magnetic memory. The present application claims priority to United States Provisional Patent Application No. 63/439,447.

### BACKGROUND ART

A spin current magnetization rotating element provided with a ferromagnetic layer whose magnetization direction is changeable and a spin-orbit torque wiring layer adjacent to the ferromagnetic layer is known.

For example, in a spin current magnetization rotating element taught in US Patent Application Publication No. 2022/0,149,269, a spin current magnetization rotating element (spintronics element) is taught wherein a perpendicular magnetization of a ferromagnetic layer is invertible by laminating a ferromagnetic layer and an antiferromagnetic layer (spin-orbit torque wiring layer) and changing a polarization direction of the spin in a spin current produced by a direction of a current flowing parallel in-plane of the antiferromagnetic layer. In US Patent Application Publication No. 2022/0,149,269, by using a canted antiferromagnetic material such as Mn₃Sn as the material of the spin-orbit torque wiring layer, it is possible to invert the spin polarization direction to change the direction of spin-orbit torque, without using exchange bias, by reversing the direction of the electric current that flows through the antiferromagnetic layer.

Furthermore, another example of a spin current magnetization rotating element, magnetoresistive effect element, and magnetic memory is taught in US Patent Application Publication No. 2019/0,267,540. In US Patent Application Publication No. 2019/0,267,540, magnetization rotation becomes possible even when a current density flowing through the spin-orbit torque wiring layer is reduced by the spin-orbit torque wiring layer having a superparamagnetic material inside.

BUHOT J ET AL.: "Experimental evidence for orthorhomnic Fddd crystal structure in elemental yttrium above 100 GPa" (ARXIV.ORG, 11 August 2020) presents electrical resistance measurements of elemental yttrium on bulk and film samples.

HE Y ET AL.: "Spin Hall conductivity in Pt films under tetragonal and orthorhombic distortions" (PHYSICA B: CONDENSED MATTER, vol. 605, 5 January 2021) shows that tensile strains in-plane can enhance the SHC (spin Hall conductivity) while the compressive ones reduce the *σ^{z}_{xy}* component of the SHC.

US Patent Application Publication No. 2019/0,006,581 describes magnetic switching devices including magnetic memory devices. The devices use high-quality crystalline films of 4d or 5d transition metal perovskite having a strong spin-orbit coupling (SOC) to produce spin-orbit torque in adjacent ferromagnetic materials via a strong spin-Hall effect.

PAI C ET AL.: "Spin transfer torque devices utilizing the giant spin Hall effect of tungsten" (APPLIED PHYSICS LETTERS, vol. 101, no. 12, 17 September 2012) reports a giant spin Hall effect in β-W thin films, and variation of the spin Hall switching efficiency with W layers of different resistivities and hence of variable (α and β) phase composition.

### CITATION LIST

### PATENT DOCUMENTS

Patent document 1: US Patent Application Publication No. 2022/0,149,269
Patent document 2: US Patent Application Publication No. 2019/0,267,540

### SUMMARY OF INVENTION

According to one aspect of the present disclosure, a spin current magnetization rotating element includes: a first ferromagnetic layer having a magnetization direction which is changeable; and a spin-orbit torque wiring layer adjacent to the first ferromagnetic layer. The spin-orbit torque wiring layer includes one element. The one element has a crystal structure in which, when dimensions of a lattice constant of the crystal structure are expressed by a, b, and c: atoms occupy internal coordinates of a unit cell: (0, 0, 0), (0.5, 0.5, 0), (0.25, 0.75, 0.25), (0.75, 0.25, 0.25), (0; 0.5, 0.5), (0.5, 0, 0.5), (0.75, 0.75, 0.75), and (0.25, 0.25, 0.75); ab planes are laminated so as to have a four-time spiral structure along c axis; and an angle between a axis and b axis (γ) is 90°, and a ratio of b to a (b/a) is in a range of 0.2 ≤ b/a ≤ 1.0.

According to another aspect of the present disclosure, a magnetoresistive effect element includes: the above-described spin current magnetization rotating element; a second ferromagnetic layer having a direction of magnetization which is fixed; and a non-magnetic layer disposed between the first ferromagnetic layer and the second ferromagnetic layer.

According to a further aspect of the present disclosure, a magnetic memory includes a plurality of the above-described magnetoresistive effect elements.

### BRIEF DESCRIPTION OF DRAWINGS

A more complete appreciation of the disclosure and many of the attendant advantages thereof will be readily obtained as the same becomes better understood by reference to the following detailed description when considered in connection with the accompanying drawings, wherein: FIG. 1 is a cross-sectional view representing one embodiment of a spin current magnetization rotating element, FIG. 2A is a conceptual view illustrating an ABCD laminated structure (a laminated structure having a four-time spiral axis), FIG. 2B is a conceptual view illustrating an ACAC laminated structure (a laminated structure having a two-time spiral axis), FIG. 3 is a graph showing total energy when b/a is changed in cases of the ABCD laminated structure (a laminated structure having a four-time spiral axis) and the ACAC laminated structure (a laminated structure having a two-time spiral axis), FIG. 4 is a cross-sectional view illustrating one embodiment of a magnetoresistive effect element, and FIG. 5 is a circuit diagram of one embodiment of a magnetic memory.

### DESCRIPTION OF EMBODIMENTS

As used herein, the words "a" and "an" and the like carry the meaning of "one or more." When an amount, concentration, or other value or parameter is given as a range, and/or its description includes a list of upper and lower values, this is to be understood as specifically disclosing all integers and fractions within the given range, and all ranges formed from any pair of any upper and lower values, regardless of whether subranges are separately disclosed. Where a range of numerical values is recited herein, unless otherwise stated, the range is intended to include the endpoints thereof, as well as all integers and fractions within the range. As an example, a stated range of 1-10 fully describes and includes the independent subrange 3.4 - 7.2 as does the following list of values: 1, 4, 6, 10.

In an embodiment of the present disclosure, a relatively large spin current is obtained when a current is flowing in a spin-orbit torque wiring layer in a spin current magnetization rotating element since the spin-orbit torque wiring layer includes a specific crystal structure. Therefore, the spin current magnetization rotating element is able to drive the magnetoresistive effect element and magnetic memory by a smaller current when used in the magnetoresistive effect element or magnetic memory.

An embodiment of each element will be described below.

### [Spin Current Magnetization Rotating Element]

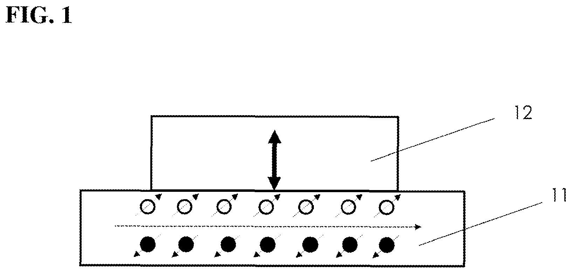

FIG. 1 is a cross-sectional view illustrating one embodiment of a spin current magnetization rotating element. A ferromagnetic layer (first ferromagnetic layer) 12 capable of magnetization rotation is laminated on a surface of a spin-orbit torque wiring layer 11.

In the spin current magnetization rotating element of the present disclosure, the spin-orbit torque wiring layer is composed of a single element or a plurality of elements, and one element in the spin-orbit torque wiring layer has a structure in which, when dimensions of a lattice constant of the crystal structure are expressed by a, b, and c: atoms occupy internal coordinates of a unit cell: (0, 0, 0), (0.5, 0.5, 0), (0.25, 0.75, 0.25), (0.75, 0.25, 0.25), (0, 0.5, 0.5), (0.5, 0, 0.5), (0.75, 0.75, 0.75), and (0.25, 0.25, 0.75), and the ab planes are laminated so as to have a four-time spiral structure along c axis; and an angle between a axis and b axis (γ) is 90°, and a ratio of b to a (b/a) is in a range of 0.2 ≤ b/a ≤ 1.0.

Furthermore, the range of b/a is preferably 0.4 ≤ b/a ≤ 0.6, and further preferably 0.47 ≤ b/a ≤ 0.55.

In one embodiment, an element having an orthorhombic structure with a space group of Fddd is included as the one or more elements included in the spin-orbit torque wiring layer 11.

In one embodiment, the spin-orbit torque wiring layer 11 contains tungsten as the one or more elements.

In one embodiment, tungsten having an orthorhombic structure with a space group of Fddd is included as the one or more elements included in the spin-orbit torque wiring layer 11.

In one embodiment, the thickness of the spin-orbit torque wiring layer 11 is 0.1 - 50 nm, preferably, 0.3 - 20 nm, more preferably, 0.5 nm- 10 nm.

The inventors of the present disclosure have discovered by performing simulations such as those described below that when orthorhombic tungsten has an orthorhombic structure with a space group of Fddd, spin Hall conductivity is generated that is larger at a Fermi level than *α*-W or *β*-W, and a similar phenomenon is expected for heavy metal elements having an atomic number equal to or greater than the atomic number of yttrium.

### (Simulation Method)

To explore crystal structures showing large spin Hall conductivity (SHC), the inventors conducted an EA (evolutionary algorithm) search following the method described in T. Ishikawa, T. Miyake, and K. Shimizu, Phys. Rev. B 100, 174506 (2019). First, (i) a population of 20 structures was built at random with the number of atoms in the calculation cell (*N*) fixed. All of the structures are fully optimized using a constant-pressure variable cell relaxation method and the density functional theory (DFT) calculations and are ranked by the total energy *E*. Next, (ii) 20 structures for the next generation were created by applying evolutionary operators (EOs), "mating" and "mutation", to the structures in the population and optimize them. The mating operator creates a slab structure based on two structures randomly chosen from the population and averages lattice parameters (*a*, *b*, *c*, *α*, *β*, and *γ*) between them, that is, the creation of a child with structural characteristics of the parents. The atoms in the cell are added or eliminated at random with *N* kept. The mutation operator changes the six lattice parameters of a structure chosen from the population, that is, the distortion of the cell. The rate of the EOs was set so that 10 structures are created by the mating operator and the other 10 structures by the mutation operator. Then, (iii) four structures with very low *E* values before the application of the EOs are passed along to the next generation. The 24 structures in the newly created population are ranked by following *E* again, and four unstable structures with very high *E* values are removed from the population. By repeatedly performing (ii) and (iii), the structures included in the population are gradually updated. Several EA searches were performed by changing *N* from 2 to 3, 4, 5, 6, 8, and 10. The EA code was combined with the Quantum ESPRESSO (QE) code (see, P. Giannozzi, et al., J. Phys.: Condens. Matter 21, 395502 (2009)) to perform the optimizations of the structures created by the EOs. The generalized gradient approximation by Perdew, Burke, and Ernzerhof (PBE) was used for the exchange-correlation functional in the framework of the projector augmented wave (PAW) method (see, e.g., P. E. Blöchl, Phys. Rev. B 50, 17953 (1994), G. Kresse and D. Joubert, Phys. Rev. B 59, 1758 (1999)). The PAW potential was obtained from the QE website (see, https://www.quantum-espresso.org/). The energy cutoff for the wave function and charge density was set at 80Ry and 640Ry, respectively. The EA search was performed using an 8 × 8 × 8 grid on the *k*-space integration over the Brillouin zone (BZ) and then the number of the *k*-point samplings (*Nₖ*) was increased to more accurately compare the energies among the predicted structures. The pressure was set at zero kbar. To check the dynamical stability of the predicted structures, phonon calculations were performed based on the density functional perturbation theory, which is implemented in the QE code.

Supposing that *Jₛ* is generated along the *x* direction with spin polarization along *z* due to *J_{c}* flowing along the *y* direction, the SHC (*σ_{xy}^{z}*) is calculated via the Kubo formula in the clean limit as follows: ${σ}_{xy}^{z} = \frac{e}{ℏ} {\int }_{BZ} \frac{d k}{{\left(2π\right)}^{3}} {\sum }_{n} {f}_{n k} {Ω}_{xy , n}^{z} \left(k\right) ,$ (1) where *fₙₖ* is the Fermi-Dirac distribution function for the nth band at *k*, and ${Ω}_{xy , n}^{z} \left(k\right) = - {\sum }_{m \neq n} \frac{2 Im \left[\left〈nk\right|{j}_{x}^{z}\left|mk\right〉\left〈mk\right|{υ}_{y}\left|nk\right〉\right]}{{\left({ϵ}_{n k}-{ϵ}_{m k}\right)}^{2}}$ (2)
is the Berry curvature of the nth band at *k*. *nk*〉 (|*mk*〉) is the Bloch state with the band index *n* (*m*) and wave-vector *k* and *∈_{n**k**}* (*∈_{m**k**}*) is the eigenvalue.
${j}_{x}^{z}$ and v_{y} are the spin current operator and the velocity operator, respectively. For the calculation of SHC, we used PBEsol functional (see, J. P. Perdew, et al., Phys. Rev. Lett. 100, 136406 (2008)) and norm-conserving fully relativistic pseudopotential generated by the Optimized Norm-Conserving Vanderbilt Pseudopotential (ONCVP) code (see, D. R. Hamann, Phys. Rev. B 88, 085117 (2013)), which was obtained from the PseudoDojo (see, M. J. van Setten, et al., Comput. Phys. Commun. 226, 39 (2018)). Spin-orbit interaction was taken into account self-consistently to treat the relativistic effects. Once the self-consistent calculations were completed by QE, the Bloch functions were Fourier transformed to the maximally localized Wannier functions (MLWFs) using the Wannier90 package (see, N. Marzari, et al., Rev. Mod. Phys. 84, 1419 (2012)). The energy cutoff for the wave function was set at 100Ry and N*ₖ* at the values from 4 × 4 × 4 to 8 × 8 × 8. in which the band structures obtained by MLWFs completely reproduce the DFT band structures in the range from -10 to 5eV. The MLWFs were utilized to calculate the Berry curvature. A dense *k* grid of 100 × 100 × 100 was used for the integration of the Berry curvature over BZ.

As the results of the EA search starting from random generation of the structures, the bcc structure corresponding to the *α* phase was obtained as the most stable structure and the *Pm*-3*n* structure corresponding to the *β* phase was obtained as the second most stable one. Subsequently, other metastable structures were investigated in the evolutionary populations. To find out the structures different from α-W and β-W, x-ray diffraction patterns of the structures were simulated in the populations by RIETAN-2000 (see, F. Izumi and T. Ikeda, Mater. Sci. Forum 321-324, 198). As the results of the comparison, 15 structures different from *α*-W and *β*-W were obtained. The space groups of the structures were assigned using FINDSYM (see, e.g., H. T. Stokes and D. M. Hatch, J. Appl. Cryst. 38, 237 (2005)). Further, the absolute values of SHC at the Fermi level (|*σ_{xy}^{z}* (0)|) for the newly predicted 15 structures (Table I) were calculated.

Simulation results for the α phase, β phase, and Fddd structure among these structures are shown in TABLE 1.

TABLE 1 shows crystal structures obtained by the structure search scheme based on first-principles calculations and an evolutionary algorithm. The structures of the *α* and *β* phases correspond to *Im*-3*m* (bcc) and *Pm*-3*n* (A15), respectively. *N*ₚ is the number of atoms in the primitive cell, Δ*E* is the energy relative to α-W and *σ_{xy}^{z}* (0) is the intrinsic spin Hall conductivity (SHC) at the Fermi level. **∈ₘₐₓ** and 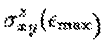 are the position from the Fermi level and the SHC value of the maximum peak, respectively. The unit of 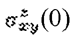 and 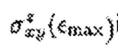 is (ℏ/*e*)(Ωcm)⁻¹.

**TABLE 1**

| Structure | *N*ₚ | Δ*E* meV /atom | 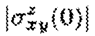 | ∈ₘₐₓ cV | 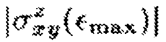 |
|---|---|---|---|---|---|
| *α* | 1 | 0 | 860 | -0.62 | 1068 |
| *β* | 8 | 88.6 | 1455 | -0.56 | 2286 |
| *Fddd* | 2 | 291.4 | 1710 | -0.01 | 1722 |

Here, the cell parameters and atomic positions of the Fddd structure are as in the Table (TABLE 2) below.

**TABLE 2: Cell parameters and atomic positions of orthorhombic Fddd structure.**

| Space group | Cell parameters | Atomic positions |
|---|---|---|
| *Fddd* (No. 70) | a = 5.34424Å | 8a 0.125 0.125 0.125 |
| | b = 2.66921Å | |
| | c = 8.98426Å | |

As shown in TABLE 1, when tungsten has an orthorhombic structure with a space group of Fddd, it is expected that the spin conductivity at the Fermi level will be larger than α-W and β-W.

Because an Fddd structure is a structure where a body centered cubic structure is spirally deformed, the one or more elements included in the spin-orbit torque wiring layer 11 are not limited to tungsten, but may be used as long as they are elements having a body centered cubic structure.

Examples of elements other than tungsten used in the spin-orbit torque wiring layer 11 include tantalum and molybdenum.

The direction of magnetization of the ferromagnetic layer 12 is changeable.

The magnetization may be parallel or inclined to the layer direction, but is preferably substantially perpendicular to the layer direction. In this disclosure, "substantially perpendicular" means having an angle of 80 to 100 degrees, preferably 85 to 95 degree, more preferably 88-92 degrees.

In one embodiment, the ferromagnetic layer 12 may contain one or more metals selected from the group composed of Co, Fe, Ni, and Gd, an alloy of these metals, a ferromagnetic body composed of a Heusler alloy such as a Cu-Mn-Al alloy or a Mn-Cu-Sn alloy, and other ferromagnetic bodies. Specific examples of other ferromagnetic bodies include oxides such as chromium (II) oxides.

In one embodiment, the ferromagnetic layer is directly laminated on the spin-orbit torque wiring layer. In another embodiment, the first ferromagnetic layer is laminated on the spin-orbit torque wiring layer via one or more other layers. The first ferromagnetic layer may be film formable as another layer disposed between spin-orbit torque wiring layers by known film forming means such as sputtering or epitaxial growth (MBE, MOCVD, and the like), and is not particularly limited. Examples of the one or more other layers in this case include a layer including, for example, Cu, Ni, and Ru as materials.

When a current is made to flow in a layer-parallel direction (for example, in the direction of the horizontal arrow in FIG. 1) in the spin-orbit torque wiring layer 11 of the spin current magnetization rotating element, a spin-current is generated in a direction orthogonal to the current by spin-orbit interaction (spin Hall effect), and spin accumulation spin-polarized perpendicularly, parallel, or obliquely to an interface between the spin-orbit torque wiring layer 11 and the ferromagnetic layer 12 is generated. The spin accumulation applies spin-orbit torque to the magnetization of the ferromagnetic layer 12 to produce magnetization rotation in the ferromagnetic layer 12.

Since a spin current relatively larger than that of a conventional element is produced in the spin current magnetization rotating element of the present disclosure, magnetization rotation is possible even when a current having a small current density is used.

[Method for Manufacturing the Spin Current Magnetization Rotating Element]

The spin current magnetization rotating element of the present disclosure may be created by the following procedures: (1) creating the spin-orbit torque wiring layer 11, (2) laminating the ferromagnetic layer 12 on the spin-orbit torque wiring layer 11, and (3) adding a voltage applying mechanism. A specific description will be given below.

### (1) Creating the spin-orbit torque wiring layer 11

The spin-orbit torque wiring layer may be created by forming a film of a material of the present disclosure on a substrate by a known film forming means such as sputtering or epitaxial growth (MBE, MOCVD, or the like).

When a spin-orbit torque wiring layer composed of tungsten having an orthorhombic structure with a space group of Fddd is created, for example, a method such as that shown in (a) to (d) below may be adopted.
(a) A GaN (1-100) substrate having an m-plane as a surface is prepared.
(b) An AlN (1-100) film is formed thereon.
(c) A Zn (1-100) film is formed thereon.
(d) A W (110) film is formed thereon.

Although it does not limit the present invention, a reason for the formation of tungsten having an orthorhombic structure with a space group of Fddd by the above method is conceivable as follows.

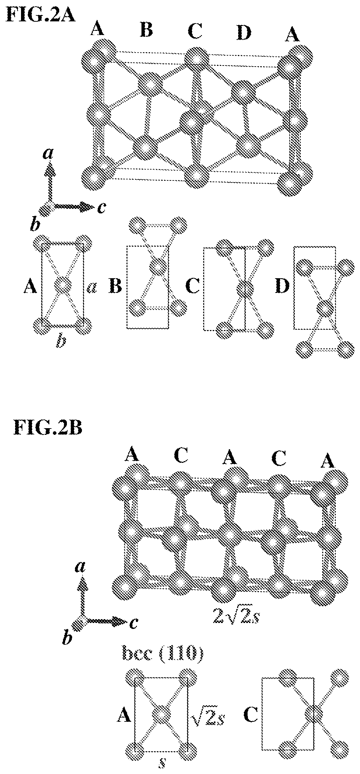

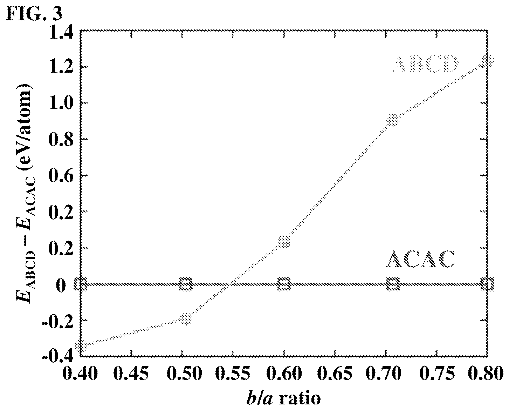

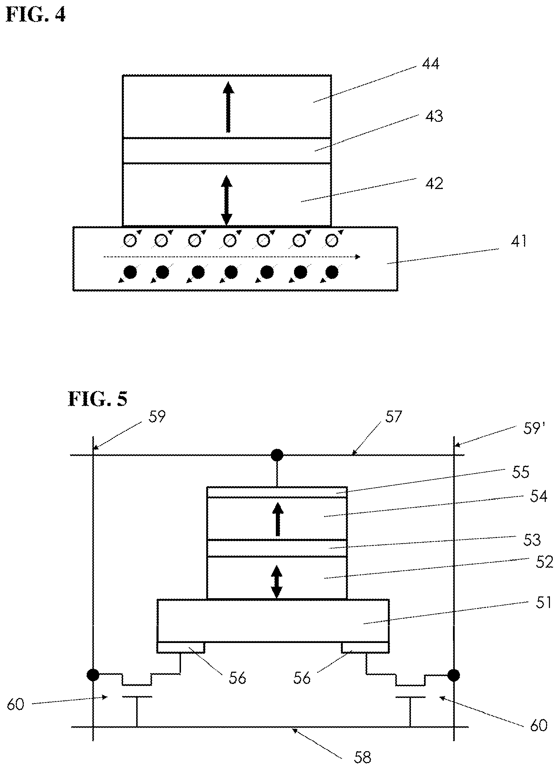

With the ABCD laminated structure illustrated in FIG. 2A (laminated in a four-time spiral structure) and the ACAC laminated structure illustrated in FIG. 2B (laminated in a two-time spiral structure), c/a was fixed to 2 and b/a was changed to make a simulated calculation of the total energy. FIG. 3 illustrates this using the relative value of when the total energy in the ACAC laminated structure is 0. The horizontal axis is b/a, and the vertical axis is the relative value of the total energy. b/a = 0.71 in the ACAC laminated structure corresponds to a body centered cubic lattice (bcc). As can be understood from FIG. 4, when b/a <0.55, the Fddd structure (ABCD laminated structure) is more stable than the ACAC laminated structure at the same b/a. Therefore, it is conceivable that when the tungsten is deformed from b/a = 0.71 corresponding to bcc (110) to near b/a = 0.55, the ABCD laminated structure is more stabilized than the ACAC laminated structure, and thus an Fddd structure is generated.

For reference, the lattice constants of α-W (110), Zn (1-100), AlN (1-100), and GaN (1-100) are shown in TABLE 3.

**TABLE 3**

| Lattice constant | b | A | b/a |
|---|---|---|---|
| α-W (110) | 3.156 | 4.43 | 0.71 |
| Zn (1-100) | 2.665 | 4.947 | 0.539 |
| AlN (1-100) | 3.11 | 4.98 | 0.624 |
| GaN (1-100) | 3.18 | 5.17 | 0.615 |

In the method described above, it is conceivable that α-W (110) is formed at approximately b/a = 0.539 on Zn (1-100), and the Fddd structure is generated before α-W is relaxed to the original b/a (0.71).

In the above method, the film forming thickness of W (110) is, for example, 1 to 10 nm, preferably 2 to 9 nm, and more preferably 3 to 8 nm.

### (2) Laminating the ferromagnetic layer 12 on the spin-orbit torque wiring layer 11

Next, the ferromagnetic layer 12 is formed on the spin-orbit torque wiring layer 11 by known film forming method such as sputtering. When sputtering is used, for example, one or more metals selected from the group composed of Co, Fe, and Ni, or an alloy of these may be used as the target material.

### (3) Adding a voltage applying mechanism

Moreover, a mechanism for applying a voltage to the spin-orbit torque wiring layer 11 is added. For example, a metal film may be formed on the spin-orbit torque wiring layer 11 by vapor deposition, sputtering, or the like, a voltage applied to the spin-orbit torque wiring layer 11 using the metal as an electrode, and a current flowed in a direction parallel to the layer. Examples of the material of the electrode include metals, ITO (indium Tin Oxide), and the like, and of these, Cu, Au, Al, and the like are exemplified as the metals.

### [Magnetoresistive Effect Element]

A known configuration may be used for the magnetoresistive effect element using a spin current magnetization rotating element. For example, the structure of the magnetoresistive effect element taught in US Patent Application Publication No. 2022/0,149,269 and US Patent Application Publication No. 2019/0,267,540 may be used. The descriptions in US Patent Application Publication No. 2022/0,149,269 and US Patent Application Publication No. 2019/0,267,540 relate to the structure of magnetoresistive effect elements.

FIG. 4 is a cross-sectional view illustrating one embodiment of a magnetoresistive effect element. A ferromagnetic layer (first ferromagnetic layer) 42 capable of magnetization rotation, a non-magnetic layer 43, and a ferromagnetic layer (second ferromagnetic layer) 44 whose magnetization direction is fixed are laminated in this order on a surface of a spin-orbit torque wiring layer 11.

The magnetization of the second ferromagnetic layer is preferably substantially perpendicular to the ferromagnetic layer but may be inclined. In this magnetoresistive effect element, a low resistance state is reached when the magnetization of the first ferromagnetic layer 42 and the magnetization of the second ferromagnetic layer 44 are oriented in the same direction (parallel state), and a high resistance state is reached when the magnetization of the first ferromagnetic layer 42 and the magnetization of the second ferromagnetic layer 44 are oriented in opposite directions (antiparallel state). Therefore, the low resistance state and the high resistance state may be switched between by rotating the magnetization of the first ferromagnetic layer 42 capable of magnetization rotation. The magnetoresistive effect element may function as a storage cell by using the difference between the resistance values before and after switching as storage information.

That is, when a current is made to flow in a layer-parallel direction (for example, in the direction of the horizontal arrow in FIG. 2) in the spin-orbit torque wiring layer 41 of the magnetoresistive effect element, a spin-current is generated in a direction orthogonal to the current by spin-orbit interaction (spin Hall effect), and spin accumulation polarized perpendicularly, parallel, or obliquely to an interface between the spin-orbit torque wiring layer 41 and the first ferromagnetic layer 42 is generated. The spin accumulation applies spin-orbit torque to the magnetization of the first ferromagnetic layer 42 to produce magnetization rotation in the ferromagnetic layer 42. Therefore, switching between the low resistance state and the high resistance state may be performed depending on the presence or absence of a current in the layer-parallel direction in the spin-orbit torque wiring layer 41.

In one embodiment, the non-magnetic layer 43 is composed of an insulator. Examples of the material of the insulator include ceramics including metal oxides, and the like, and as the metal oxide, magnesium oxide is exemplified.

In one embodiment, the non-magnetic layer 43 is a metal. Examples of the metal include Cu and Ru.

The second ferromagnetic layer 44 has a fixed magnetization direction. A known method may be adopted to fix the magnetization direction. For example, a holding force of the second ferromagnetic layer 44 may be made larger than a holding force of the first ferromagnetic layer 42. Furthermore, the magnetization direction of the second ferromagnetic layer 44 may be fixed by exchange coupling with the antiferromagnetic layer.

In one embodiment, the second ferromagnetic layer 44, similarly to the first ferromagnetic layer 42, may contain one or more metals selected from the group composed of Co, Fe, Ni, and Gd, an alloy of these metals, a ferromagnetic body composed of a Heusler alloy such as a Cu-Mn-Al alloy or a Mn-Cu-Sn alloy, and other ferromagnetic bodies. Specific examples of other ferromagnetic bodies include oxides such as chromium dioxide.

The first ferromagnetic layer 42 and the second ferromagnetic layer 44 may be formed from the same material or may be formed from different materials. From the perspective of increasing the difference between the low resistance state and the high resistance state, the magnetization direction of the first ferromagnetic layer 42 and the magnetization direction of the second ferromagnetic layer 44 are preferably close to parallel or antiparallel. That is, if the magnetization direction of the first ferromagnetic layer 42 is substantially perpendicular to the layer direction, the magnetization direction of the second ferromagnetic layer 44 is also preferably substantially perpendicular to the layer direction, and if the magnetization direction of the first ferromagnetic layer 42 is substantially parallel to the layer direction, the magnetization direction of the second ferromagnetic layer 44 is also preferably substantially parallel to the layer direction.

The magnetoresistive effect element of the present disclosure may be created by the following procedures: (1) creating the spin-orbit torque wiring layer 41, (2) laminating the first ferromagnetic layer 42 on the spin-orbit torque wiring layer 41, (3) laminating the non-magnetic layer 43 on the first ferromagnetic layer 42, (4) laminating the second ferromagnetic layer 44 on the non-magnetic layer 43, and (5) adding a voltage application mechanism.

Of these, (1) creating the spin-orbit torque wiring layer 41, (2) laminating the first ferromagnetic layer 42 on the spin-orbit torque wiring layer 41, and (5) adding a voltage application mechanism are similar to those described in the method for manufacturing the spin current magnetization rotating element, and therefore descriptions thereof will be omitted.

### (3) Laminating the first ferromagnetic layer 42 on the non-magnetic layer 43

A non-magnetic layer 43 film is formed on the first ferromagnetic layer 42 by known film forming means such as sputtering. When sputtering is used, a material capable of forming the non-magnetic layer may be used as the target material.

### (4) Laminating the second ferromagnetic layer 44 on the non-magnetic layer 43

Next, a second ferromagnetic layer 44 film is formed on the non-magnetic layer 43 by a known film forming means such as sputtering. When sputtering is used, similar to the first ferromagnetic layer, for example, one or more metals selected from the group composed of Co, Fe, and Ni, or an alloy of these may be used as the target material.

In the magnetoresistive effect element of the present disclosure, a relatively large spin current is generated in the spin-orbit torque wiring layer, and therefore, the resistance may be switched at a small current.

### [Magnetic Memory]

A magnetic memory may be configured by using a plurality of the magnetoresistive effect element described above as a storage cell. A known configuration may be used for the magnetic memory using a spin current magnetization rotating element. For example, the structure of the magnetic memory taught in US Patent Application Publication No. 2022/0,149,269 and US Patent Application Publication No. 2019/0,267,540 may be used. The descriptions in US Patent Application Publication No. 2022/0,149,269 and US Patent Application Publication No. 2019/0,267,540 relate to the structure of magnetic memory.

FIG. 5 is a circuit diagram illustrating one embodiment of wiring of a storage cell configuring a portion of the magnetic memory of the present disclosure. A plurality of the storage cells such as illustrated in FIG. 5 are arranged in a matrix and driven.

In each storage cell, a ferromagnetic layer (first ferromagnetic layer) 52 capable of magnetization rotation, a non-magnetic layer 53, and a ferromagnetic layer (second ferromagnetic layer) 54 whose magnetization direction is fixed are laminated in this order on a surface of a spin-orbit torque wiring layer 51, thereby forming a magnetoresistive effect element. The operation of the magnetoresistive effect element in the magnetic memory is similar to that described for the magnetoresistive effect element, above.

Two supply electrodes 56, 56 are provided to the spin-orbit torque wiring layer 51 and the supply electrode 56, 56 are connected to sources of transistors 60, 60, respectively. Gates of the transistors 60, 60 are connected to a word line 58, and drains of the two transistors 60, 60 are connected to a first write bit line 59 and a second write bit line 59', respectively. The second ferromagnetic layer 54 is connected to the read bit line 57 via an electrode 55.

Here, data "1" is assigned to the high resistance state and data "0" is assigned to the low resistance state, for example. When the data "1" is written to the storage cell where the data "0" is written, the first write bit line 59 is set to an H (high voltage) level and the second write bit line 59' is set to an L (low voltage) level. Then, by setting the word line 58 to an H level, a current flows through the spin-orbit torque wiring layer 51 from the first write bit line 59 toward the second write bit line 59', the magnetization of the first ferromagnetic layer 52 is inverted, and the data "1" is written.

Conversely, for example, when the data "0" is written to the storage cell where the data "1" is written, the first write bit line 59 is set to an L level and the second write bit line 59' is set to an H level. Then, by setting the word line 58 to an H level, a current flows through the spin-orbit torque wiring layer 51 from the second write bit line 59' toward the first write bit line 59, the magnetization of the first ferromagnetic layer 52 is inverted, and the data "0" is written.

When reading the data stored in the storage cell, one of either the first write bit line 59 or the second write bit line 59' is set to an H level and the other is opened. Further, by setting the read bit line 57 to an L level and setting the word line 58 to an H level, a current flows from the first write bit line 59 and the second write bit line 59' to the read bit line 57, and therefore, by measuring the magnitude of this current, it is determined whether the storage cell is in the high resistance state or the low resistance state, and data written in the storage cell is acquired.

In one embodiment of the magnetic memory, a predetermined write/read operation is performed by arraying storage cells such as illustrated in FIG. 5 on a matrix and controlling the levels of the write bit line, the read bit line, and the word line by a controller.

In the magnetic memory of the present embodiment, a relatively large spin current is generated in the spin-orbit torque wiring layer, and therefore, the magnetic memory may be operated at a small current.

Obviously, numerous modifications and variations of the present invention are possible in light of the above teachings. It is therefore to be understood that within the scope of the appended claims, the invention may be practiced otherwise than as specifically described herein.

### INDUSTRIAL APPLICABILITY

In embodiments of the present disclosure, a relatively large spin current is obtained when a current is flowing in a spin-orbit torque wiring layer in a spin current magnetization rotating element since the spin-orbit torque wiring layer includes a specific crystal structure. Therefore, the spin current magnetization rotating element is able to drive the magnetoresistive effect element and magnetic memory by a smaller current when used in the magnetoresistive effect element or magnetic memory.

### REFERENCE SIGNS LIST

- 11: spin-orbit torque wiring layer
- 12: ferromagnetic layer
- 41: spin-orbit torque wiring layer
- 42: first ferromagnetic layer
- 43: non-magnetic layer
- 44: second ferromagnetic layer
- 51: spin-orbit torque wiring layer
- 52, 54: ferromagnetic layer
- 53: non-magnetic layer
- 55, 56: electrode
- 57: read bit line
- 58: word line
- 59: first write bit line
- 59': second write bit line
- 60: transistor

## Claims

1. A spin current magnetization rotating element comprising:
a first ferromagnetic layer (12, 42, 52) having a magnetization direction which is changeable; and
a spin-orbit torque wiring layer (11, 41, 51) adjacent to the first ferromagnetic layer,
wherein the spin-orbit torque wiring layer comprises one element, and **characterized in that**
the one element has a crystal structure in which,
when dimensions of a lattice constant of the crystal structure are expressed by a, b, and c:
atoms occupy internal coordinates of a unit cell: (0, 0, 0), (0.5, 0.5, 0), (0.25, 0.75, 0.25), (0.75, 0.25, 0.25), (0, 0.5, 0.5), (0.5, 0, 0.5), (0.75, 0.75, 0.75), and (0.25, 0.25, 0.75);
ab planes are laminated so as to have a four-time spiral structure along c axis; and
an angle between a axis and b axis (γ) is 90°, and a ratio of b to a (b/a) is in a range of 0.2 ≤ b/a ≤ 1.0.

2. The spin current magnetization rotating element according to claim 1, wherein the one element included in the spin-orbit torque wiring layer comprises a heavy metal element having an atomic number equal to or greater than an atomic number of yttrium.

3. The spin current magnetization rotating element according to claim 2, wherein the heavy metal element is tungsten.

4. The spin current magnetization rotating element according to claim 2, wherein the heavy metal element is tungsten having an orthorhombic structure with a space group of Fddd.

5. The spin current magnetization rotating element according to any one of claims 1 to 4, wherein b/a is in a range of 0.4 ≤ b/a ≤ 0.6.

6. The spin current magnetization rotating element according to any one of claims 1 to 5, wherein b/a is in a range of 0.47 ≤ b/a ≤ 0.55.

7. The spin current magnetization rotating element according to any one of claims 1 to 6, further comprising a substrate composed of a semiconductor or an insulator, wherein the spin-orbit torque wiring layer is formed on the substrate directly or via an intermediate layer.

8. A magnetoresistive effect element comprising:
the spin current magnetization rotating element according to any one of claims 1 to 7;
a second ferromagnetic layer (44, 54) having a direction of magnetization which is fixed; and
a non-magnetic layer (43, 53) disposed between the first ferromagnetic layer and the second ferromagnetic layer.

9. A magnetic memory comprising a plurality of the magnetoresistive effect elements according to claim 8.

## Patentansprüche

1. Spin-Strom-Magnetisierungsrotationselement, umfassend:
eine erste ferromagnetische Schicht (12, 42, 52) mit einer Magnetisierungsrichtung, die veränderbar ist; und
eine Spin-Bahn-Drehmoment-Verdrahtungsschicht (11, 41, 51), die an die erste ferromagnetische Schicht angrenzt,
wobei die Spin-Bahn-Drehmoment-Verdrahtungsschicht ein Element umfasst, und
**dadurch gekennzeichnet, dass**
das eine Element eine Kristallstruktur aufweist, in der,
wenn die Abmessungen einer Gitterkonstante der Kristallstruktur durch a, b und c ausgedrückt werden:
Atome innere Koordinaten einer Elementarzelle einnehmen: (0, 0, 0), (0,5, 0,5, 0), (0,25, 0,75, 0,25), (0,75, 0,25, 0,25), (0, 0,5, 0,5), (0,5, 0, 0,5), (0,75, 0,75, 0,75) und (0,25, 0,25, 0,75);
ab-Ebenen so geschichtet sind, dass sie entlang der c-Achse eine vierfache Spiralstruktur aufweisen; und
ein Winkel zwischen a-Achse und b-Achse (γ) 90 ° beträgt, und ein Verhältnis von b zu a (b/a) in einem Bereich von 0,2 ≤ b/a ≤ 1,0 liegt.

2. Spin-Strom-Magnetisierungsrotationselement nach Anspruch 1, wobei das eine in der Spin-Bahn-Drehmoment-Verdrahtungsschicht enthaltene Element ein Schwermetallelement umfasst, dessen Ordnungszahl gleich oder größer als eine Ordnungszahl von Yttrium ist.

3. Spin-Strom-Magnetisierungsrotationselement nach Anspruch 2, wobei das Schwermetallelement Wolfram ist.

4. Spin-Strom-Magnetisierungsrotationselement nach Anspruch 2, wobei das Schwermetallelement Wolfram ist, das eine orthorhombische Struktur mit einer Raumgruppe Fddd aufweist.

5. Spin-Strom-Magnetisierungsrotationselement nach einem der Ansprüche 1 bis 4, wobei b/a in einem Bereich von 0,4 ≤ b/a ≤ 0,6 liegt.

6. Spin-Strom-Magnetisierungsrotationselement nach einem der Ansprüche 1 bis 5, wobei b/a in einem Bereich von 0,47 ≤ b/a ≤ 0,55 liegt.

7. Spin-Strom-Magnetisierungsrotationselement nach einem der Ansprüche 1 bis 6, ferner umfassend ein Substrat, das aus einem Halbleiter oder einem Isolator zusammengesetzt ist, wobei die Spin-Bahn-Drehmoment-Verdrahtungsschicht direkt oder über eine Zwischenschicht auf dem Substrat gebildet ist.

8. Magnetowiderstandseffekt-Element, umfassend:
das Spin-Strom-Magnetisierungsrotationselement nach einem der Ansprüche 1 bis 7;
eine zweite ferromagnetische Schicht (44, 54) mit einer Magnetisierungsrichtung, die fest ist; und
eine nichtmagnetische Schicht (43, 53), die zwischen der ersten ferromagnetischen Schicht und der zweiten ferromagnetischen Schicht angeordnet ist.

9. Magnetischer Speicher, umfassend eine Vielzahl von Magnetowiderstandseffekt-Elementen nach Anspruch 8.

## Revendications

1. Élément de rotation de magnétisation par courant de spin comprenant :
une première couche ferromagnétique (12, 42, 52) dont la direction de magnétisation est modifiable ; et
une couche de câblage à couple spin-orbite (11, 41, 51) adjacente à la première couche ferromagnétique,
dans laquelle la couche de câblage à couple spin-orbite comprend un élément, et **caractérisée en ce que**
cet élément présente une structure cristalline dans laquelle,
lorsque les dimensions d'une constante de réseau de la structure cristalline sont exprimées par a, b et c :
les atomes occupent les coordonnées internes d'une maille élémentaire : (0, 0, 0), (0,5, 0,5, 0), (0,25, 0,75, 0,25), (0,75, 0,25, 0,25), (0, 0,5, 0,5), (0,5, 0, 0,5), (0,75, 0,75, 0,75) et (0,25, 0,25, 0,75) ;
les plans ab sont stratifiés de manière à présenter une structure en spirale quadruple le long de l'axe c ; et
l'angle entre l'axe a et l'axe b (γ) est de 90°, et le rapport de b sur a (b/a) se situe dans une plage comprise entre 0,2 ≤ b/a ≤ 1,0.

2. Élément de rotation de magnétisation par courant de spin selon la revendication 1, dans lequel l'élément inclus dans la couche de câblage de couple spin-orbite comprend un élément de métal lourd ayant un numéro atomique égal ou supérieur au numéro atomique de l'yttrium.

3. Élément de rotation de magnétisation par courant de spin selon la revendication 2, dans lequel l'élément de métal lourd est le tungstène.

4. Élément de rotation de magnétisation par courant de spin selon la revendication 2, dans lequel l'élément de métal lourd est le tungstène présentant une structure orthorhombique avec un groupe d'espace Fddd.

5. Élément de rotation de magnétisation par courant de spin selon l'une quelconque des
revendications 1 à 4, dans lequel b/a est compris dans l'intervalle 0,4 ≤ b/a ≤ 0,6. s

6. Élément de rotation de magnétisation par courant de spin selon l'une quelconque des revendications 1 à 5, dans lequel b/a est compris dans l'intervalle 0,47 ≤ b/a ≤ 0,55.

7. Élément de rotation de magnétisation par courant de spin selon l'une quelconque des revendications 1 à 6, comprenant en outre un substrat composé d'un semi-conducteur ou d'un isolant, dans lequel la couche de couche de câblage à couple spin-orbite est formée sur le substrat directement ou via une couche intermédiaire.

8. Élément à effet magnétorésistif comprenant :
l'élément de rotation de magnétisation par courant de spin selon l'une quelconque des revendications 1 à 7 ;
une deuxième couche ferromagnétique (44, 54) ayant une direction de magnétisation fixe ; et
une couche non magnétique (43, 53) disposée entre la première couche ferromagnétique et la deuxième couche ferromagnétique.

9. Mémoire magnétique comprenant une pluralité d'éléments à effet magnétorésistif selon la revendication 8.
